# EUROPEAN PATENT APPLICATION

(11) **EP 4 484 606 A1**
(43) Date of publication of application: **01.01.2025**
(21) Application number: 23765718.4
(22) Date of filing: 10.02.2023
(51) Int. Cl.: C23C 14/34, C23C 14/50

(54) **HIGH-THROUGHPUT THIN FILM DEPOSITION APPARATUS, ETCHING APPARATUS AND ETCHING METHOD**

(30) Priority: 09.03.2022 CN 202210224445; 14.07.2022 CN 202210834295
(71) Applicant: Shanghai Institute of IC Materials, Shanghai 201800 (CN)
(72) Inventor: LI, Weimin, Shanghai 201800 (CN); CHEN, Lingli, Shanghai 201800 (CN)
(74) Representative: Canzler & Bergmeier Patentanwälte Partnerschaft mbB
(86) International application number: PCT/CN2023/075408
(87) International publication number: WO 2023/169140

(57) **Abstract**

Provided in the present invention are a high-throughput thin film deposition apparatus, a high-throughput etching apparatus and an etching method. The high-throughput thin film deposition or the high-throughput etching apparatus comprises a reaction chamber, a carrying platform control device and a process isolation device, wherein the carrying platform control device comprises a substrate carrying platform and a main carrying platform, and the substrate carrying platform is located on the main carrying platform; the substrate carrying platform is configured to carry a substrate to be deposited or to be etched and drive the substrate to operate, and the main carrying platform is configured to carry the substrate carrying platform and drive the substrate carrying platform to operate; and the process isolation device is configured to provide a process isolation area located above the substrate carrying platform. Process isolation during a process is achieved by means of the process isolation area, so that the process is only carried out in the process isolation area, such that an isolation process is carried out on local areas of the substrate. In addition, combined with the operation of the carrying platform control device, an independent and uniform process for multiple local areas on the single substrate is finally achieved. The apparatus of the present invention has a simple structure and a wide applicability, is easy to operate and capable of preparing a high-uniformity thin film and etching morphology, and has good practicability.

## Description

### FIELD OF THE INVENTION

The present disclosure belongs to the technical field of film preparation in semiconductor process, and particularly relates to a high-throughput film deposition equipment, an etching equipment and a method thereof.

### BACKGROUND OF THE INVENTION

Physical vapor deposition (PVD) is a widely used technology for film preparation. Sputtering can be used to prepare high-quality films at lower cost and faster deposition speed. However, current PVD equipment can only prepare materials with one composition and one thickness on a single wafer at one time, that is, using one set of process conditions per cycle in the operation. However, developing new materials requires numerous process steps, therefore using traditional PVD equipment will consume significant amount of time and money so is too inefficient. Therefore, it is necessary to have high-throughput film deposition equipment.

Current high-throughput film deposition equipment has been used for developing multi-component materials. The resulting high-throughput films are usually non-uniform, having uneven material composition ratios within a single film, and each specific composition ratio often only exists in to one small area. Such non-uniform high-throughput films lead to new materials discovery. For example, X-ray photoelectron spectroscopy can characterize the elemental composition and valence states of each composite material, revealing the basic properties of the material. However, for commercial devices, high-throughput films with more uniform composition and thickness in all areas is desired.

Therefore, it is urgent to develop a new high-throughput film deposition equipment, etching equipment, and method thereof.

### SUMMARY OF THE INVENTION

The present disclosure provides a high-throughput film -deposition equipment, an etching equipment and a method thereof, which can solve the problem that the existing high-throughput film deposition equipment, etching equipment and etching method fail to meet current demands.

The high-throughput process equipment includes: a reaction chamber; a stage control apparatus, wherein the stage control apparatus comprises a substrate stage and a main stage located within the reaction chamber; wherein the substrate stage is located on the main stage, and carries a substrate to be deposited or etched and moves the substrate; wherein the main stage carries the substrate stage and drives the substrate stage to move; and
a process isolation apparatus, wherein the process isolation apparatus is located within the reaction chamber and provides a process isolation zone above the substrate stage, wherein an isolation range of the process isolation zone is smaller than the substrate, such that processes are carried out only within the process isolation zone to isolate the processes within a local region of the substrate; and wherein the process isolation apparatus and the stage control apparatus combine to achieve independent and uniform processes for multiple local regions on the substrate.

In some examples, the process isolation apparatus further comprises a mask plate, wherein the mask plate is located within the reaction chamber and positioned above the substrate stage, with a gap set between the mask plate and the substrate stage, wherein the mask plate is provided with at least one through-hole penetrating the mask plate along a thickness direction, and wherein the mask plate provides process isolation in the process isolation zone.

In some examples, the process isolation apparatus further includes a sputtering gun, which is located within the reaction chamber and positioned above the mask plate, with a space between the sputtering gun and the mask plate, wherein the sputtering gun for provides elemental particles required for deposition.

In some examples, the process isolation apparatus further includes a gas supplying apparatus located in the reaction chamber and above the substrate stage, wherein the gas supplying apparatus provides an inert gas curtain around the process isolation zone to achieve isolation, wherein the inert gas curtain is composed of an inert gas, wherein the inert gas is blown from the gas supplying apparatus towards the substrate, wherein a top of the inert gas curtain is in contact with the gas supplying apparatus and a bottom of the inert gas curtain is in contact with the substrate, and wherein the inert gas curtain divides the substrate into two zones, of which, a zone enclosed by the inert gas curtain is used for processes, and a zone outside the inert gas curtain is not affected by the processes.

In some examples, the process isolation apparatus further includes a process gas inlet surrounded by the inert gas curtain, wherein a process gas is supplied through the process gas inlet for processes of the substrate.

In some examples, a central axis of the main stage coincides with a central axis of the process isolation zone, the central axis of the main stage does not coincide with a central axis of the substrate stage, and the central axis of the substrate stage coincides with a central axis of the substrate, wherein regions of the substrate to be deposited or to be etched are located under the process isolation zone.

In some examples, the substrate stage drives the substrate to perform one or more of translation and rotation, and/or the main stage drives the substrate stage to perform one or more of translation and rotation.

In some examples, the stage control apparatus comprises: a substrate stage driving apparatus, connected with the substrate stage and is used to drive the substrate stage; and a main stage driving apparatus, connected with the main stage and is used to drive the main stage; wherein when the substrate stage driving apparatus drives the substrate stage, the main stage driving apparatus stops operating, and when the main stage driving apparatus drives the main stage, the substrate stage driving apparatus stops operating.

In some examples, the substrate stage driving apparatus is a rotary lifting driving apparatus; and/or the main stage driving apparatus is a rotary lifting driving apparatus.

In some examples, a shape of the process isolation zone comprises one or more of circle, rectangle, triangle, and trapezoid.

In some examples, the equipment can be applied to physical vapor deposition, CVD, pulsed laser deposition, and dry etching, wherein the CVD comprises plasma-enhanced CVD.

The disclosure includes a high-throughput processing method, includes steps of: S-a: providing an equipment described above; S-b: keeping the substrate stage stationary on the main stage, driving the substrate stage with the main stage, and carrying out a process on the substrate below the process isolation zone, to form a local process region; S-c: keeping the main stage stationary, driving the substrate with the substrate stage, and moving another to-be-processed local region of the substrate to be under the process isolation zone; and S-d: repeating steps S-b and S-c at least one more time to carry out processes separately on multiple local regions of the substrate.

As discussed above, the present disclosure provides a high-throughput film deposition equipment, an etching equipment and a method thereof; the high-throughput film deposition equipment or etching equipment includes a reaction chamber, a stage control apparatus, and a process isolation apparatus; the stage control apparatus includes a substrate stage and a main stage in the reaction chamber; the substrate stage is on the main stage, and carries a substrate to be deposited or etched and to drive the substrate to move; the main stage is configured to carry the substrate stage and to drive the substrate stage to move; the process isolation apparatus is located within the reaction chamber and is configured to provide a process isolation zone above the substrate stage, an isolation range of the process isolation zone being smaller than the substrate, such that processes are carried out only within the process isolation zone, thereby isolating the processes within a local region of the substrate, and in combination with operations of the stage control apparatus, achieving independent and uniform processes for multiple local regions of the substrate.

When applied to a high-throughput film PVD apparatus, the process isolation apparatus is a mask plate and provides the process isolation zone to realize film process isolation. When applied to a high-throughput film chemical vapor deposition (CVD) apparatus or a high-throughput dry etching equipment, the process isolation apparatus is a gas supplying apparatus and provides an inert gas curtain to realize isolation for the process isolation zone.

The high-throughput film deposition equipment and etching equipment of the present disclosure have two stages and a process isolation apparatus, which can realize independent and uniform processes in multiple local regions of a single substrate, and the apparatus is simple in structure, widely applicable, and easy to operate; the homogeneity and etching morphology of the prepared high-throughput film can be improved; the prepared high-throughput film can be used for a wider range of material characterization and can also be used for further apparatus preparation and the like; therefore the present disclosure has a high practical value.

### BRIEF DESCRIPTION OF DRAWINGS

FIG. 1 shows a schematic structural diagram of a high-throughput film PVD apparatus according to Embodiment 1 of the present disclosure.
FIG. 2 shows a flowchart illustrating a high-throughput film PVD method according to Embodiment 1 of the present disclosure.
FIG. 3 shows a top view of the main and substrate stages in the high-throughput film deposition or etching according to embodiments of the present disclosure.
FIG. 4 shows a flowchart illustrating a method in high-throughput film CVD and etching according to Embodiment 2 of the present disclosure.
FIG. 5 shows a schematic structural diagram of a high-throughput film CVD and etching equipment according to Embodiment 2 of the present disclosure.

### Reference Numerals

- 12: Process Gas Control Valve
- 13: Process Gas Inlet
- 14: Process Gas
- 15: Process Gas Line
- 16: Gas Supplying Apparatus
- 17: Inert Gas Control Valve
- 18: Inert Gas Line
- 19: Inert Gas Curtain
- 20: Reaction Gas Control Valve
- 21: Reaction Gas Line
- 22: Sputtering Gas Control Valve
- 23: Sputtering Gas Line
- 24: Sputtering Gun
- 25: Mask Plate
- 26: Substrate Stage
- 27: Main Stage
- 28: Main Stage Driving Apparatus
- 29: Substrate Stage Driving Apparatus
- 30: Reaction Chamber
- S1~S4, S2-1-S2-4: Various process Steps

### DETAILED DESCRIPTION

The embodiments of the present disclosure will be described below. Those skilled can easily understand advantages and effects of the present disclosure according to contents disclosed by the specification. The present disclosure can also be implemented or applied through other different exemplary embodiments. Various modifications or changes can also be made to all details in the specification based on different points of view and applications without departing from the spirit of the present disclosure.

When describing the embodiments of the present disclosure, for better explanation, cross-sectional structural diagrams may be partially enlarged without following the general scale. Moreover, the diagrams are only examples and should not limit the scope of the present disclosure. In addition, the actual production should include the length, width and depth of the three-dimensional space dimensions.

For the convenience of description, spatial relation terms such as "below", "under", "beneath", "on", "above", "up", etc. may be used herein to describe the relationships between an element or feature and other elements or features. It will be understood that these spatial relationship terms are intended to encompass directions/orientations of the apparatus in use or operation other than those depicted in the drawings. In addition, when a first layer is referred to as being "between" a second layer and a third layer, the first layer may be the only layer between the second and third layers, or there may more layers between the two layers. When an element is "fixed onto" or "disposed on" another element, it may be directly or indirectly on the other element. When an element is "attached to" or "connected to" another element, it may be directly or indirectly attached/connected to the other element.

Expressions such as "between ......" may be used herein to indicate that two endpoints of the range are included, and expressions such as "several" may be used to indicate two or more, unless explicitly and specifically qualified otherwise. In addition, the terms like "first" and "second" are used for descriptive purpose only, and are not to be construed as indicating or implying relative importance or implicitly specifying numbers of technical features indicated. Thus, features qualified with terms like "first" and "second" may explicitly or implicitly include one or more such features.

It should be noted that the drawings provided in this disclosure only illustrate the basic concept of the present disclosure in a schematic way, so the drawings only show the components closely related to the present disclosure. The drawings are not necessarily drawn according to the number, shape and size of the components in actual implementation; during the actual implementation, the type, quantity and proportion of each component can be changed as needed, and the components' layout may also be more complicated.

The present disclosure provides an equipment for high-throughput film deposition and high-throughput etching, including:
a reaction chamber;
a stage control apparatus, wherein the stage control apparatus includes: a substrate stage and a main stage located within the reaction chamber; wherein the substrate stage is located on the main stage, and is configured to carry a substrate to be deposited or etched and to drive the substrate to move; wherein the main stage is configured to carry the substrate stage and to drive the substrate stage to move;
a process isolation apparatus, wherein the process isolation zone apparatus is located within the reaction chamber and is configured to provide a process isolation zone above the substrate stage, an isolation range of the process isolation zone being smaller than the substrate, such that processes are carried out only within the process isolation zone, thereby isolating the processes within a local region of the substrate, and in combination with operations of the stage control apparatus, achieving independent and uniform processes for multiple local regions of the substrate.

The present embodiments also provide a high-throughput process method which can be either for a film deposition or for an etching, including:
S-a: providing the equipment;
S-b: keeping the substrate stage stationary on the main stage, driving the main stage and the substrate stage, and carrying out a process on the substrate below the process isolation zone, to form a local process region;
S-c: keeping the main stage stationary, driving the substrate with the substrate stage, and moving another to-be-processed local region of the substrate to be under the process isolation zone;
S-d: repeating steps S-b and S-c at least one more time to carry out processes separately on multiple local regions of the substrate.

The high-throughput film process method for deposition or high-throughput etching method is described below by means of specific embodiments.

### Embodiment 1

Existing high-throughput film deposition equipment and deposition methods fail to prepare films with good homogeneity, referring to patents or applications CN208008884U, CN109355621A, WO2019047167A1, etc.

As shown in the table below, the applicant evaluated the homogeneity of films deposited by the high-throughput film deposition equipment; the high-throughput film deposition equipment in the evaluation includes two 4-inch sputtering guns, i.e., an aluminum sputtering gun and a copper sputtering gun; both sputtering guns are amounted at an angle of 50° with the horizontal plane; the height of the guns is arranged to be from the substrate surface at 12 cm apart; the central axis of the substrate and the confocal central axis of the two sputtering guns are coaxial; the distortion variable here is whether the substrate is rotated so has an angular distortion, and when the substrate is rotated, it is usually rotated around its central axis. Substrate thickness uniformity measurements were taken over circular areas of 5-cm diameters, and elemental homogeneity measurements were taken over circular areas of 1.5-cm diameter.

| | Rotated | Not rotated |
|---|---|---|
| Thickness uniformity | 0.6% | 6.2% |
| Compositional homogeneity (average aluminum percentage at% ± standard deviation) | 33.8%±0.3% | 49.8%±14.5% |

Thus, substrate rotation yields better thickness uniformity as well as elemental compositional homogeneity. In previously quoted high-throughput PVD patents, single-point deposition typically did not involve substrate manipulation, such as rotation or translation. The focus was solely on high throughput and gradient distribution of elements and thickness, without considering the uniformity of elements and thickness. This leads to issues of non-uniformity during multi-target co-sputtering. Therefore, a new design is needed to achieve uniformity.

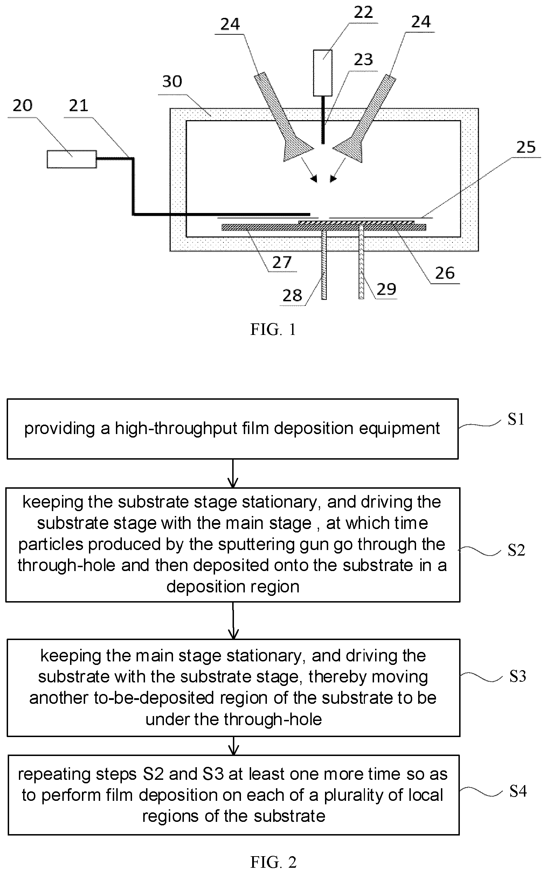

As shown in FIG. 1, the present disclosure provides a high-throughput film PVD apparatus, and the high-throughput film PVD apparatus includes a reaction chamber 30, a stage control apparatus, a mask plate 25 and a sputtering gun 24; the stage control apparatus includes a substrate stage 26 and a main stage 27 located in the reaction chamber 30, and the substrate stage 26 is located on the main stage 27, the substrate stage 26 is used to carry a substrate to be deposited (not shown) and to drive the substrate, and the main stage 27 is used to carry the substrate stage 26 and to drive the substrate stage 26; the mask plate 25 is located in the reaction chamber 30 and above the substrate stage 26, spaced from the substrate stage 26, the mask plate 25 is provided with at least one through-hole penetrating the mask plate 25 in a thickness direction; the sputtering gun 24 is located within the reaction chamber 30 and above the mask plate 25; it is spaced apart from the mask plate 25, and provides deposition metal elemental particles required for deposition.

Herein, the high-throughput film PVD apparatus has two stages (the main stage and the substrate stage); during film deposition using the high-throughput film PVD apparatus, elemental particles are generated by the sputtering gun 24, and the substrate stage 26 is first stationary with respect to the main stage 27, at which time the main stage 27 drives the substrate stage 26, and elemental particles are deposited through the through hole in the mask plate 25 onto the substrate, resulting in a deposition region; then the main stage 27 is stationary, at which time the substrate stage 26 drives the substrate to rotate, thereby moving another to-be-processed local region of the substrate to be under the through-hole; then the above steps are repeated to deposit in a plurality of local regions of the substrate respectively, so as to prepare a high-throughput film with a high homogeneity.

It is to be noted that the substrate may have only one single layer or have stacked layers in order to perform zoned film deposition on the substrate.

As an example, the high-throughput film deposition equipment includes a film deposition equipment applied to PVD, CVD or pulsed laser deposition; the CVD may include plasma-enhanced CVD apparatus. A description of the high-throughput film CVD apparatus may be found in Embodiment 2.

Specifically, as shown in FIG. 1, the high-throughput film PVD apparatus of the present disclosure further includes a gas system, and the gas system includes a sputtering gas system and a reaction gas system, wherein the sputtering gas system includes a sputtering gas control valve 22 and a sputtering gas line 23, and the reaction gas system includes a reaction gas control valve 20 and a reaction gas line 21, the reaction gas control valve 20 and sputtering gas control valve 22 are located outside of the reaction chamber 30 and may be, for example, a mass flow controller. The reactive gas line 21 and the sputtering gas line 23 are connected to corresponding gas control valves and lead to various functional areas inside the reaction chamber 30, and sputtering gas is provided in the vicinity of the sputtering gun 24 and reactive gas is provided in the vicinity of the substrate.

In one example, the high-throughput film deposition equipment is an apparatus suitable for PVD and is a PVD apparatus suitable for sputtering; the high-throughput film deposition equipment of FIG. 1 may also be adapted to be suitable for different fields of applications by modifying the high-throughput film deposition equipment, for example, by adding a heating apparatus or the like, so that the high-throughput film deposition equipment becomes suitable for vaporization PVD, or adaptively improved to be suitable for, e.g., CVD, wherein the CVD may be plasma-enhanced CVD or other CVD, or adaptively improved to be suitable for, e.g., pulsed laser deposition.

By way of example, the central axis of the main stage 27 coincides with the central axis of the through-hole, the central axis of the main stage 27 does not coincide with the central axis of the substrate stage 26, and the central axis of the substrate stage 26 coincides with the central axis of the substrate, with the region of the substrate to be deposited being located under the through-hole.

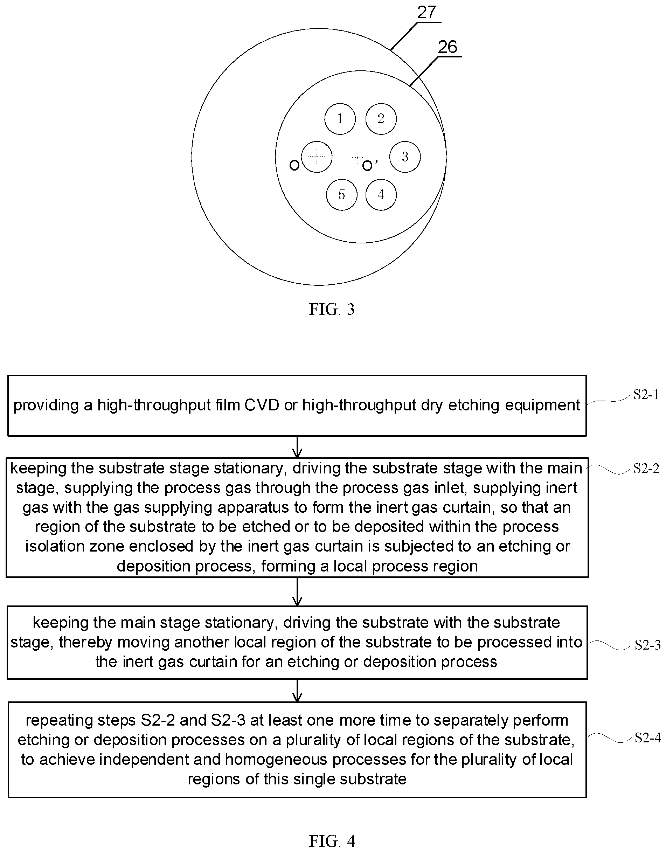

Specifically, as shown in FIG. 3, the center O of the main stage 27 does not coincide with the center O' of the substrate stage 26, the center O' of the substrate stage 26 coincides with the center of the substrate, and the substrate stage 26 covers the center O of the main stage 27, such that the region of the substrate to be deposited is located under the through-hole; it is preferred that the main stage 27 and the substrate stage 26 both operate in a rotating manner, wherein the main stage 27 has an axis of rotation coinciding with the central axis of the through-hole of the mask plate, the substrate stage 26 has an axis of rotation coinciding with the central axis of the substrate, the substrate stage 26 covers the center O of the main stage 27 such that the region of the substrate to be deposited is located directly under the through-hole, so as to facilitate deposition of elemental particles onto the substrate through the through-hole.

As an example, the substrate stage 26 drives the substrate to perform one or more of translations and rotations; and the main stage 27 drives the substrate stage to perform one or more of translations and rotations.

Specifically, in one embodiment, the substrate stage 26 drives the substrate to operate in a rotational manner, and the main stage 27 drives the substrate stage 26 to operate in a rotational manner, in order to facilitate the deposition of a more homogeneous film; in another embodiment, that the substrate stage 26 operates in a translational manner, and the main stage 27 operates in a rotational manner; or one of the substrate stage 26 and the main stage 27 operates in a translational manner, and the other operates in a rotational manner. The manner of operation of the substrate stage 26 and the main stage 27 is not unduly limited herein.

As an example, the stage control apparatus includes:
a substrate stage driving apparatus 29, connected to the substrate stage 26 for driving the substrate stage 26;
a main stage driving apparatus 28, connected to the main stage 27 for driving the main stage 27;
when the substrate stage driving apparatus 29 drives the substrate stage 26, the main stage driving apparatus 28 stops operating, and when the main stage driving apparatus 28 drives the main stage 27, the substrate stage driving apparatus 29 stops operating.

Specifically, in one embodiment, in the process of depositing a film, the substrate stage 26 first stays stationary, and elemental particles go through the through holes of the mask plate 25 to form a deposition region on the substrate, and the deposition region rotates around its center as driven by the main stage driving apparatus 28 until the deposition for this region completes; The substrate stage driving apparatus 29, in turn, controls the rotation of the substrate, and one by one, exposes other regions of the substrate to the through-holes in the mask plate 25, followed by a new round of deposition under the action of the main stage driving apparatus 28. Repeat the deposition process for each to-be-deposited region of the substrate, and eventually, a plurality of local regions with separate but uniform deposition is formed on the substrate.

The substrate stage driving apparatus 29 and the main stage driving apparatus 28 may be controlled by respective corresponding controllers, and may also be controlled by the same controller; the substrate stage driving apparatus 29 and the main stage driving apparatus 28 are independent of each other but are capable of cooperating with each other so that the main stage driving apparatus 28 ceases to operate when the substrate stage driving apparatus 29 operates, and the main stage driving apparatus 28 ceases to operate when the substrate stage driving apparatus 29 operates.

As an example, the substrate stage driving apparatus 29 is a rotary lifting driving apparatus; and/or the main stage driving apparatus is a rotary lifting driving apparatus.

Specifically, the substrate stage driving apparatus 29 and the main stage driving apparatus 28 may both be rotary lifting driving apparatus or only one of them is a rotary lifting driving apparatus in order to change the height of the substrate through lifting by the substrate stage driving apparatus 29 and/or the main stage driving apparatus 28, facilitating the control of film deposition.

As an example, orifice shape of the through-hole may be one or more of a circle, a rectangle, a triangle, and a trapezoid.

Specifically, the through-hole of the mask plate 25 may be circular, rectangular, triangular, trapezoidal, etc., and its size is also varied and can be adjusted according to actual needs.

As an example, the high-throughput film deposition equipment includes N sputtering guns 24, N≥1.

Specifically, as in FIG. 1, in one embodiment, the high-throughput film deposition equipment includes two sputtering guns 24, and it is preferred that the two sputtering guns 24 are confocal; the number of the sputtering guns 24 may also be three, four, five, etc., which may be arranged according to actual needs.

As an example, there is also included an adjustment apparatus (not shown) connected to each sputtering gun 24 for adjusting the height and angle of the sputtering gun 24.

Specifically, the adjustment apparatus drives the sputtering gun 24 to move up and down, and the adjustment apparatus may include, for example, an adjusting lever.

As in FIG. 2, the present disclosure also provides a film deposition method, including:
S1: providing the high-throughput film deposition equipment;
S2: keeping the substrate stage 26 stationary, and driving the substrate stage 26 with the main stage 27, at which time elemental particles produced by the sputtering gun 24 go through the through-hole and then deposited onto the substrate in a deposition region;
S3: keeping the main stage 27 stationary, and driving the substrate with the substrate stage 26, thereby moving another to-be-deposited region of the substrate to be under the through-hole;
S4: repeating steps S2 and S3 at least one more time so as to perform film deposition on each of a plurality of local regions of the substrate.

The structure of the high-throughput film deposition equipment is not described herein, details of which can be found in the above description of the high-throughput film deposition equipment.

Specifically, as in FIG. 3, when preparing a film by deposition using the high-throughput film deposition equipment, the substrate to be deposited is placed on the substrate stage 26, and elemental particles supplied by the sputtering gun 24 are deposited onto the substrate through the (circular, e.g.) through hole of the mask plate 25, forming a circular deposition region, and during this first deposition process, the substrate stage 26 does not move and the main stage driving apparatus 28 controls the main stage 27 to rotate around the central axis of the main stage 27, meaning that the circular deposition region is also rotated around its center by the main stage driving apparatus 28, and the elemental particles can be uniformly distributed and deposited in the region until the deposition for this region completes. Thereafter, the main stage driving apparatus 28 ceases to operate, and the substrate stage driving apparatus 29 is activated to control the substrate stage 26 to rotate about its central axis for a certain angle and then the substrate stage driving apparatus 29 ceases to operate, at which time the previously deposited circular deposition region has been moved to a masked area below the mask plate 25, and elemental particles of a new round of deposition will not impact this previously deposited circular deposition region. Exposed by the through-hole of the mask plate 25 at this time is another to-be-deposited region of the substrate, and elemental particles are deposited onto the substrate through the through-hole of the mask plate 25, forming a new circular deposition region, during which deposition the substrate stage 26 does not move, and the main stage driving apparatus 28 controls the main stage 27 to rotate about its central axis, meaning that the new circular deposition region is rotated around its center by the main stage driving apparatus 28 until the deposition for this new region completes. The above deposition steps are repeated until depositions for a plurality of independent regions of the substrate are completed; as shown in FIG. 3, Regions 1 to 5 are a plurality of independent regions of the substrate.

### Embodiment 2

Embodiment 2 provides a high-throughput apparatus, which differs from Embodiment 1 mainly in that the process isolation apparatus in Embodiment 1 is the mask plate 25 and process isolation is achieved by providing the process isolation zone through the mask plate 25, as well as providing the elemental particles required for deposition through the sputtering gun 24; whereas Embodiment 2 provides an apparatus applied to, for example, high-throughput film CVD or high-throughput dry etching, wherein the process isolation apparatus is a gas supplying apparatus within the reaction chamber and above the substrate stage, providing an inert gas curtain to produce isolation for the process isolation zone; the inert gas curtain includes inert gas blown from the gas supplying apparatus to the substrate to be deposited or to be etched; the inert gas curtain has a top in contact with the gas supplying apparatus and a bottom in contact with the substrate to be deposited or to be etched; the inert gas curtain divides the substrate to be deposited or to be etched into two zones, of which, the zone enclosed by the inert gas curtain is utilized for chemical vapor-phase film deposition or dry etching, and the zone outside the inert gas curtain is not affected by the processes.

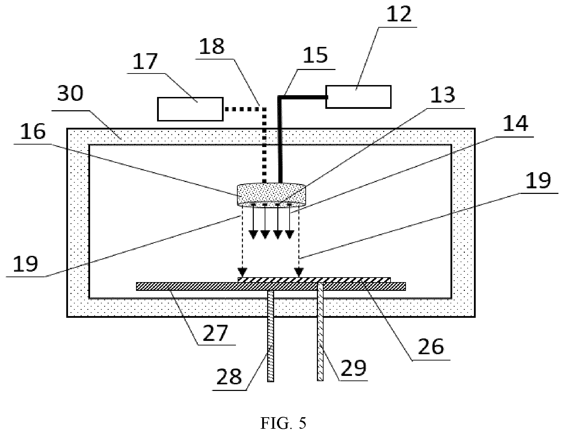

Specifically, as in FIG. 5, the apparatus applied to high-throughput process which can be either a film CVD or a dry etching includes a reaction chamber 30, a stage control apparatus, and a gas control system; the stage control apparatus includes a substrate stage 26 and a main stage 27 located in the reaction chamber 30, and the substrate stage 26 is located on the main stage 27, the substrate stage 26 is used to carry a substrate to be deposited or to be etched (not shown) and to drive the substrate, and the main stage 27 is used to carry the substrate stage 26 and to drive the substrate stage 26; the gas control system includes a process gas control system, an inert gas control system, and an exhaust system (not shown); the process gas control system includes a process gas control valve 12, a process gas inlet 13, a process gas 14, and a process gas line 15; the inert gas control system includes a gas supplying apparatus 16, an inert gas control valve 17, an inert gas line 18, and an inert gas. The process gas control valve 12 and inert gas control valve 17 are located outside the reaction chamber 30 and may be mass flow controllers, for example. The process gas line 15 and inert gas line 18 are connected to corresponding gas control valves and lead to functional areas within the reaction chamber 30. The inert gas is provided by the gas supplying apparatus 16 located above the substrate stage, and the inert gas forms an inert gas curtain 19 that resembles a cylinder; the top of the inert gas curtain 19 is in contact with the gas supplying apparatus 16 and the bottom of the inert gas curtain 19 is in contact with the substrate to be etched or to be deposited (not shown). The inert gas curtain 19 divides the substrate to be etched or to be deposited into two zones, of which one zone is enclosed by the inert gas curtain 19 and is an etching or deposition zone, and the other zone outside the curtain is not affected by the etching or deposition process. The process gas 14 provided is enclosed by the inert gas curtain 19; the process gas 14 exits through the process gas inlet 13, the process gas inlet 13 may be provided on the gas supplying apparatus 16 or may be provided inside the inert gas curtain 19 and below the gas supplying apparatus 16; the process gas inlet 13 provides the process gas 14 for etching or deposition. The inert gas and the process gas 14 are discharged from the reaction chamber 30 via an exhaust system; under the action of the exhaust system, the inert gas and the process gas 14 will not flow out of the process isolation zone (not shown).

As an example, the stage control apparatus includes a substrate stage 26 and a main stage 27, and the substrate stage 26 is located on the main stage 27, and the substrate stage 26 is used to carry the substrate to be deposited or etched and to drive the substrate, and the main stage 27 is used to carry the substrate stage 26 and to drive the substrate stage 26.

The apparatus of Embodiment 2 has two stages; when etching or depositing a substrate, the substrate stage 26 is first stationary with respect to the main stage 27, at which time the main stage 27 drives the substrate stage 26 to operate, to etch or deposit on an region of the substrate to be etched or to be deposited within the inert gas curtain 19, forming a process region; thereafter the main stage 27 is stationary and the substrate stage 26 drives the substrate, thereby moving another region of the substrate to be processed to be within the inert gas curtain 19 for a process, such as etching or deposition; the above steps of etching or deposition are repeated to process each of a plurality of local regions of the substrate.

It is to be noted that the substrate here may have only a single layer or have a stack of layers, such as a stacked substrate structure having a deposited film on its surface to perform a zoned etch of the deposited film, or a substrate structure having only a single layer to perform a zoned etch of the substrate directly.

As an example, the substrate stage 26 drives the substrate to perform one or more of translation and rotation; and/or the main stage 27 drives the substrate stage to perform one or more of translation and rotation.

As an example, the stage control apparatus includes:
a substrate stage driving apparatus 29, connected to the substrate stage 26 for driving the substrate stage 26;
a main stage driving apparatus 28, connected to the main stage 27 for driving the main stage 27;
when the substrate stage driving apparatus 29 drives the substrate stage 26, the main stage driving apparatus 28 stops operating, and when the main stage driving apparatus 28 drives the main stage 27, the substrate stage driving apparatus 29 stops operating.

As an example, the substrate stage driving apparatus 29 is a rotary lifting driving apparatus; and/or the main stage driving apparatus is a rotary lifting driving apparatus.

The structure and operation of the stage control apparatus of the apparatus are detailed in Embodiment 1, other parts of the apparatus that are not described herein can be flexibly set according to specific needs.

Referring to FIG. 4, the present disclosure also provides a high-throughput film CVD or high-throughput dry etching method, including:
S2-1: providing the high-throughput film CVD or high-throughput dry etching equipment as described above;
S2-2: keeping the substrate stage 26 stationary, driving the substrate stage 26 with the main stage 27, supplying the process gas 14 through the process gas inlet 13, supplying inert gas with the gas supplying apparatus 16 to form the inert gas curtain 19, so that a region of the substrate to be etched or to be deposited within the process isolation zone enclosed by the inert gas curtain 19 is subjected to an etching or deposition process, forming a local process region;
S2-3: keeping the main stage 27 stationary, driving the substrate with the substrate stage 26, thereby moving another local region of the substrate to be processed into the inert gas curtain 19 for an etching or deposition process;
S2-4: repeating steps S2and S3 at least one more time to separately perform etching or deposition processes on a plurality of local regions of the substrate, to achieve independent and homogeneous processes for the plurality of local regions of this single substrate.

As an example, during etching or deposition, the substrate to be etched or deposited is first placed on the substrate stage 26; the main stage 27 is stationary at first, at which time the substrate is driven by the substrate stage 26 to move into the reserved area of the to-be-formed inert gas curtain 19; then the process gas 14 and inert gas are provided to form the inert gas curtain 19, wherein the process gas is provided within the inert gas curtain 19; then the substrate stage 26 is stationary, at which time the main stage 27 drives the substrate stage 26 to move, so that the region of the substrate to be etched or deposited is located within the inert gas curtain 19, following by first etching or deposition; during this first etching or deposition, the substrate stage 26 is stationary, and the main stage driving apparatus 28 controls the main stage 27 to rotate about its central axis, meaning that the region of the substrate to be etched or deposited is rotated around its center throughout the first etching or deposition until the etching or deposition for this region completes, which enables homogeneous etching or deposition. Then, the main stage driving apparatus 28 ceases to operate and the substrate stage driving apparatus 29 starts controlling the substrate stage 26 to rotate around its central axis for a certain angle; then the substrate stage driving apparatus 29 ceases to operate; by this time, a new region of the substrate to be etched or deposited has been moved into the inert gas curtain 19 for second etching or deposition; during the second etching or deposition, the substrate stage 26 stays stationary and the main stage driving apparatus 28 controls the main stage 27 to rotate about its central axis, meaning that the new region of the substrate to be etched or deposited is driven by the main stage driving apparatus 28 to rotate about its center until the etching or deposition for this region completes. The above etching or deposition steps are repeated until the etching or deposition processes for a plurality of independent local regions of the substrate are completed. The inert gas curtain 19 and the exhaust system may be on at all times during or between etching or deposition processes, in order to protect areas that are not to be etched or deposited; the process gas 14 is only on during etching or deposition processes, and is off between etching or deposition processes. As shown in FIG. 3, Regions 1 to 5 represent a plurality of independent etching or deposition regions of the substrate. The regions may be circular, square, etc., as needed.

In summary, the high-throughput film deposition equipment, the etching equipment and the method thereof are disclosed herein; the high-throughput film deposition or high-throughput etching equipment includes a reaction chamber, a stage control apparatus and a process isolation apparatus; the stage control apparatus includes a substrate stage and a main stage in the reaction chamber; the substrate stage is on the main stage, and carries a substrate to be deposited or etched and to drive the substrate to move; the main stage is configured to carry the substrate stage and to drive the substrate stage to move; the process isolation apparatus is located within the reaction chamber and is configured to provide a process isolation zone above the substrate stage, an isolation range of the process isolation zone being smaller than the substrate, such that processes are carried out only within the process isolation zone, thereby isolating the processes within a local region of the substrate, and in combination with operations of the stage control apparatus, achieving independent and uniform processes for multiple local regions of the substrate.

When applied to a high-throughput film PVD apparatus, the process isolation apparatus is a mask plate and provides the process isolation zone to realize film process isolation. When applied to a high-throughput film CVD apparatus or a high-throughput dry etching equipment, the process isolation apparatus is a gas supplying apparatus and provides an inert gas curtain to realize isolation for the process isolation zone.

The high-throughput film PVD apparatus includes a reaction chamber, a stage control apparatus, a mask plate, and a sputtering gun; the mask plate is within the reaction chamber and above the substrate stage, spaced apart from the substrate stage; the mask plate is provided with at least one through-hole penetrating the mask plate in a thickness direction; the sputtering gun is within the reaction chamber and above the mask plate, and spaced apart from the mask plate, and provides the elemental particles required for deposition; The high-throughput film CVD apparatus or high-throughput film dry etching equipment includes a reaction chamber, a stage control apparatus, a gas control system; the gas control system includes a process gas control system, an inert gas control system, and an exhaust system (not shown); the inert gas control system generates an inert gas; the inert gas forms an inert gas curtain, which divides the substrate to be etched or deposited into two zones; the zone enclosed by the inert gas curtain (i.e., a process isolation zone) is an etching zone or a deposition zone; the process gas control system generates a process gas, and the process gas is used for etching or deposition on the substrate in the etching zone or the deposition zone within the inert gas curtain; the inert gas and the process gas are discharged out of the reaction chamber through an exhaust system, and under the action of the exhaust system, the inert gas and the process gas will not flow out of the process isolation zone.

**The** high-throughput film deposition equipment and etching equipment of the present disclosure have two stages (the main stage and the substrate stage) and a process isolation apparatus, which can realize independent and uniform processes in multiple local regions of a single substrate, and the apparatus is simple in structure, widely applicable, and easy to operate; the homogeneity and etching morphology of the prepared high-throughput film can be improved; the prepared high-throughput film can be used for a wider range of material characterization and can also be used for further apparatus preparation and the like; therefore the present disclosure has a high practical value.

The above-mentioned embodiments are merely illustrative of the principle and effects of the present disclosure instead of restricting the scope of the present disclosure. Any person skilled in the art may modify or change the above embodiments without violating the principle of the present disclosure. Therefore, all equivalent modifications or changes made by those who have common knowledge in the art without departing from the spirit and technical concept disclosed by the present disclosure shall be still covered by the claims of the present disclosure.

## Claims

1. A high-throughput process equipment, wherein the high-throughput process equipment is one of a film deposition equipment or an etching equipment, wherein the high-throughput process equipment comprises:
a reaction chamber;
a stage control apparatus, wherein the stage control apparatus comprises a substrate stage and a main stage located within the reaction chamber; wherein the substrate stage is located on the main stage, and carries a substrate to be deposited or etched and moves the substrate; wherein the main stage carries the substrate stage and drives the substrate stage to move; and
a process isolation apparatus, wherein the process isolation apparatus is located within the reaction chamber and provides a process isolation zone above the substrate stage, wherein an isolation range of the process isolation zone is smaller than the substrate, such that processes are carried out only within the process isolation zone to isolate the processes within a local region of the substrate; and wherein the process isolation apparatus and the stage control apparatus combine to achieve independent and uniform processes for multiple local regions on the substrate.

2. The high-throughput process equipment according to claim 1, wherein the process isolation apparatus comprises a mask plate, wherein the mask plate is located within the reaction chamber and positioned above the substrate stage, with a gap set between the mask plate and the substrate stage, wherein the mask plate is provided with at least one through-hole penetrating the mask plate along a thickness direction, and wherein the mask plate provides process isolation in the process isolation zone.

3. The high-throughput process equipment according to claim 2, further comprising a sputtering gun, which is located within the reaction chamber and positioned above the mask plate, with a space between the sputtering gun and the mask plate, wherein the sputtering gun for provides elemental particles required for deposition.

4. The high-throughput process equipment according to claim 1, wherein the process isolation apparatus comprises a gas supplying apparatus located in the reaction chamber and above the substrate stage, wherein the gas supplying apparatus provides an inert gas curtain around the process isolation zone to achieve isolation, wherein the inert gas curtain is composed of an inert gas, wherein the inert gas is blown from the gas supplying apparatus towards the substrate, wherein a top of the inert gas curtain is in contact with the gas supplying apparatus and a bottom of the inert gas curtain is in contact with the substrate, and wherein the inert gas curtain divides the substrate into two zones, of which, a zone enclosed by the inert gas curtain is used for processes, and a zone outside the inert gas curtain is not affected by the processes.

5. The high-throughput process equipment according to claim 4, further comprising a process gas inlet surrounded by the inert gas curtain, wherein a process gas is supplied through the process gas inlet for processes of the substrate.

6. The high-throughput process equipment t according to claim 1, wherein a central axis of the main stage coincides with a central axis of the process isolation zone, the central axis of the main stage does not coincide with a central axis of the substrate stage, and the central axis of the substrate stage coincides with a central axis of the substrate, wherein regions of the substrate to be deposited or to be etched are located under the process isolation zone.

7. The high-throughput process equipment according to claim 1, wherein the substrate stage drives the substrate to perform one or more of translation and rotation, and/or the main stage drives the substrate stage to perform one or more of translation and rotation.

8. The high-throughput process equipment according to claim 1, wherein the stage control apparatus comprises:
a substrate stage driving apparatus, connected with the substrate stage and is used to drive the substrate stage; and
a main stage driving apparatus, connected with the main stage and is used to drive the main stage;
wherein when the substrate stage driving apparatus drives the substrate stage, the main stage driving apparatus stops operating, and when the main stage driving apparatus drives the main stage, the substrate stage driving apparatus stops operating.

9. The high-throughput process equipment according to claim 8, wherein the substrate stage driving apparatus is a rotary lifting driving apparatus; and/or the main stage driving apparatus is a rotary lifting driving apparatus.

10. The high-throughput process equipment according to claim 1, wherein a shape of the process isolation zone comprises one or more of circle, rectangle, triangle, and trapezoid.

11. The high-throughput process equipment according to claim 1, comprising equipment applied to physical vapor deposition, CVD, pulsed laser deposition, and dry etching, wherein the CVD comprises plasma-enhanced CVD.

12. A high-throughput processing method, comprising:
S-a: providing an equipment according to any of claims 1-11;
S-b: keeping the substrate stage stationary on the main stage, driving the substrate stage with the main stage, and carrying out a process on the substrate below the process isolation zone, to form a local process region;
S-c: keeping the main stage stationary, driving the substrate with the substrate stage, and moving another to-be-processed local region of the substrate to be under the process isolation zone; and
S-d: repeating steps S-b and S-c at least one more time to carry out processes separately on multiple local regions of the substrate.
